# FASCICULE DE BREVET EUROPEEN

(11) **EP 1 759 467 B1**
(45) Date de publication et mention de la délivrance du brevet: **13.08.2008**
(21) Numéro de dépôt: 05778875.4
(22) Date de dépôt: 20.06.2005
(51) Int. Cl.: H04B 3/54, G01D 4/00, H02H 1/00, G01R 22/00

(54) **PROCEDE ET DISPOSITIF DE TRANSMISSION D'UNE INFORMATION VIA UN RESEAU DE DISTRIBUTION D'ELECTRICITE**
VERFAHREN UND VORRICHTUNG ZUR INFORMATIONSÜBERTRAGUNG IN EINEM STROMVERTEILUNGSNETZ
METHOD AND DEVICE FOR TRANSMITTING INFORMATION THROUGH A POWER DISTRIBUTION NETWORK

(30) Priorité: 21.06.2004 FR 0406727
(43) Date de publication de la demande: 07.03.2007
(73) Titulaire: Watteco, 83130 La Garde (FR)
(72) Inventeur: BERTRAND, Paul, F-83390 Pierrefeu du Var (FR)
(74) Mandataire: Marchand, André
(86) Numéro de dépôt international: PCT/FR2005/001534
(87) Numéro de publication internationale: WO 2006/008381

(56) Documents cités:
- EP-A- 1 136 829
- WO-A-00/26679
- GB-A- 1 153 908
- GB-A- 2 008 299
- US-A- 3 714 451
- US-A- 4 090 184
- US-A- 4 982 175
- US-A- 5 483 153
- US-A- 5 486 805
- US-A- 5 614 811
- US-A1- 2002 024 423
- US-A1- 2003 156 014

## Description

La présente invention concerne un procédé et un dispositif pour transmettre une information par l'intermédiaire d'un réseau de distribution d'électricité.

La ligne électrique est utilisée depuis de nombreuses années comme moyen de transmission de données à faible débit, notamment dans les applications domotiques, pour contrôler à distance des équipements électriques (par exemple des volets électriques). Les procédés de transmission de données connus consistent dans l'injection, dans le réseau, d'un signal de porteuse qui est modulé d'une manière appropriée pour véhiculer des données. L'inconvénient de ces procédés est de nécessiter l'injection d'un tel signal de porteuse. Ils sont donc intrusifs et perturbateurs, et complexes à mettre en oeuvre.

La présente invention vise un procédé pour la transmission d'une information via un réseau de distribution d'électricité qui soit moins intrusif et moins perturbateur que les procédés connus. Les applications visées sont notamment la transmission de données binaires mais également la transmission d'une information non binaire, par exemple une suite d'impulsions ayant un profil prédéterminé permettant d'identifier un appareil électrique sans nécessiter une reconstruction de l'information sous forme binaire.

Comme exposé dans le brevet EP 1 136 829, tout appareil ou élément électrique, notamment moteur, pompe, transformateur, ampoule électrique, circuit électrique ou électronique, génère à sa mise sous tension et à sa mise hors tension un signal parasite haute fréquence ayant une origine électromagnétique. Ce signal étant de très courte durée, il forme une impulsion parasite haute fréquence émise naturellement par l'élément électrique. Une telle impulsion parasite forme une sorte de signature unique qui est représentative de l'appareil électrique et de sa localisation sur le réseau de distribution d'électricité. Ainsi, le brevet EP 1 136 829 propose de détecter et d'analyser les impulsions haute fréquence émises sur le réseau par des appareils électriques, afin d'identifier les appareils qui sont mis sous tension ou hors tension.

Le brevet précité enseigne également de prévoir un synthétiseur d'impulsions capable de fournir une impulsion se substituant à l'impulsion parasite émise naturellement lorsque celle-ci est d'une amplitude trop faible pour être valablement détectée. Est également envisagée l'utilisation d'un synthétiseur d'impulsions pour émettre une suite d'impulsions comprenant un nombre d'impulsions déterminé formant une signature unique.

Classiquement, un synthétiseur d'impulsions capable d'émettre une suite d'impulsions comprend par exemple un interrupteur HF générateur d'impulsions, un oscillateur HF, un circuit logique et un transformateur de sortie. L'oscillateur HF fournit un signal haute fréquence de commutation de l'interrupteur HF. Le circuit logique fournit un signal codé qui est mélangé avec le signal de commutation pour obtenir un signal de contrôle de l'interrupteur. Le transformateur de sortie permet de réinjecter dans le réseau de distribution d'électricité les suites d'impulsions HF artificiellement reconstituées.

Toutefois, un tel synthétiseur d'impulsions présente un prix de revient et un encombrement qui ne sont pas négligeables dans le contexte des applications visées, lesquelles concernent les marchés de masse et exigent des prix de revient très faibles.

Ainsi, la présente invention prévoit de transmettre une information sur un réseau de distribution d'électricité sans utiliser un synthétiseur d'impulsions.

Plus particulièrement, la présente invention prévoit de transmettre une information en utilisant les impulsions parasites haute fréquence émises naturellement par un élément électrique lorsque celui-ci est connecté ou déconnecté du réseau. A cet effet, l'élément électrique est relié au réseau par un interrupteur et l'interrupteur est piloté par un signal de contrôle représentatif de l'information à transmettre. Ainsi, les impulsions parasites haute fréquence émises par l'élément électrique sont l'image du signal de contrôle qui est lui-même l'image de l'information à transmettre. La durée de telles impulsions, d'origine électromagnétique, est très faible et est indépendante du temps s'écoulant entre la fermeture et l'ouverture de l'interrupteur, qui peut être nettement plus long.

Dans l'art antérieur, on a déjà proposé divers procédés de transmission de données basés sur l'émission d'impulsions dans un réseau de distribution d'électricité. Il s'agit généralement d'impulsions de tension ou de courant générées par la décharge d'un condensateur, la durée de la décharge formant la durée de l'impulsion. Ces impulsions de tension ou de courant sont directement injectées dans le réseau au moyen d'un interrupteur ou sont injectées par couplage inductif. Pour être détectées, elles nécessitent l'injection dans le réseau d'une énergie électrique non négligeable.

Avec l'invention, l'énergie électrique devant être appliquée au réseau peut au contraire être très faible voire quasiment nulle (dans la limite des lois de la physique et des phénomènes inductifs) car ce n'est pas une impulsion de tension ou de courant porteuse d'énergie qui est détectée, mais une impulsion parasite haute fréquence qui accompagne la connexion ou la déconnexion de l'élément électrique.

Dans l'art antérieur, des impulsions parasites haute fréquence sont peut-être involontairement émises simultanément à l'émission d'impulsions de tension ou de courant, mais de telles impulsions parasites émises involontairement ne sont pas utilisées en tant que moyen de transmission d'information et ne sont donc pas détectées en tant que telles.

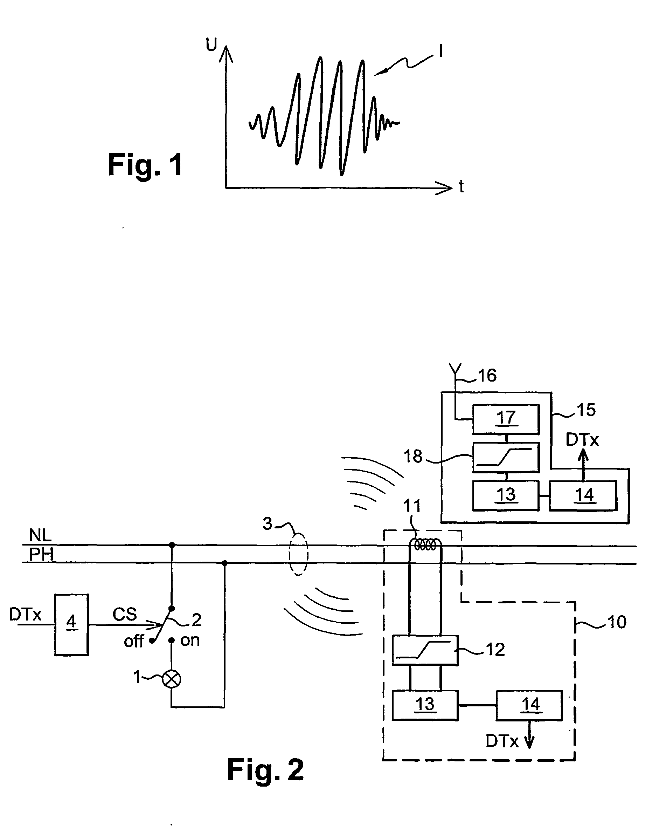

Ainsi, le document GB 1 153 908 décrit un procédé de transmission de données consistant à décharger un condensateur 4 dans le réseau électrique (Cf. page 2 lignes 55-121, figures 1 à 3) et à détecter les impulsions de décharge qui se superposent à la tension alternative du réseau.

Le document US 4 090 184 décrit également un procédé de transmission de données par décharge de condensateur (Cf. colonne 17 lignes 22-34) et détection des impulsions de décharge.

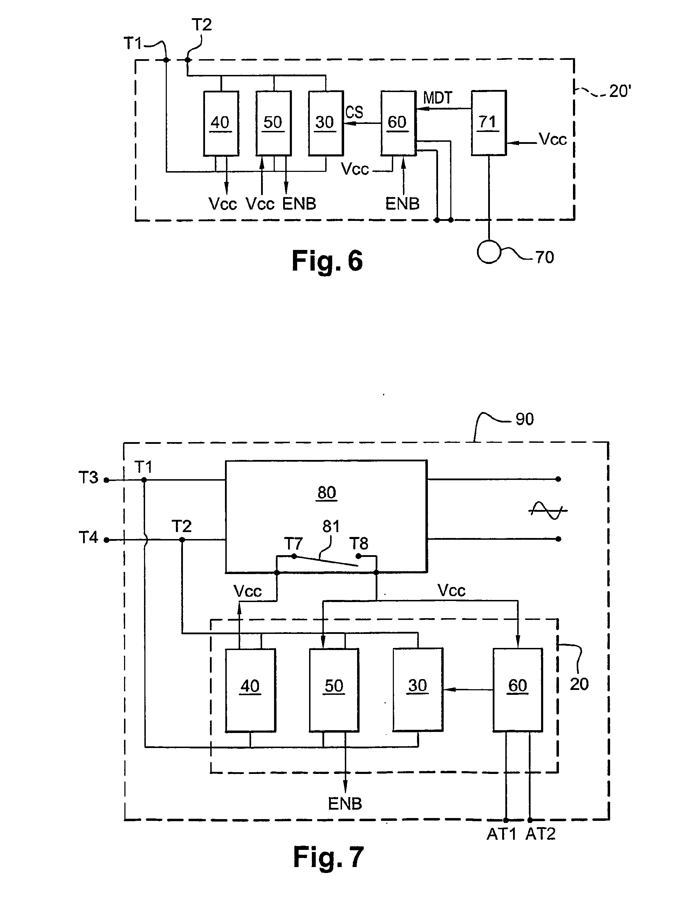

Le document US 5 614 811 décrit également un procédé de transmission de données par décharge de condensateur (Cf. revendication 1, dernière ligne). De plus, ce procédé est perturbateur pour le réseau électrique puisque le condensateur est déchargé à des moments où la tension alternative passe par zéro (Cf. fig. 7, colonne 3 ligne 61 à colonne 4 ligne 16).

Le document GB 2 008 299 décrit également un procédé de transmission de données par décharge de condensateur 20 (Cf. revendication 1, dernière ligne, figure 1). Dans ce procédé également, le condensateur peut être déchargé à des moments où l'onde de la tension alternative passe par 0 (Cf. fig. 18, "signal pulses at zero crossing").

Le document US 5 486 805 décrit également un procédé comprenant l'émission d'impulsions par décharge d'un condensateur au passage à zéro de la tension alternative (Cf. figure 1).

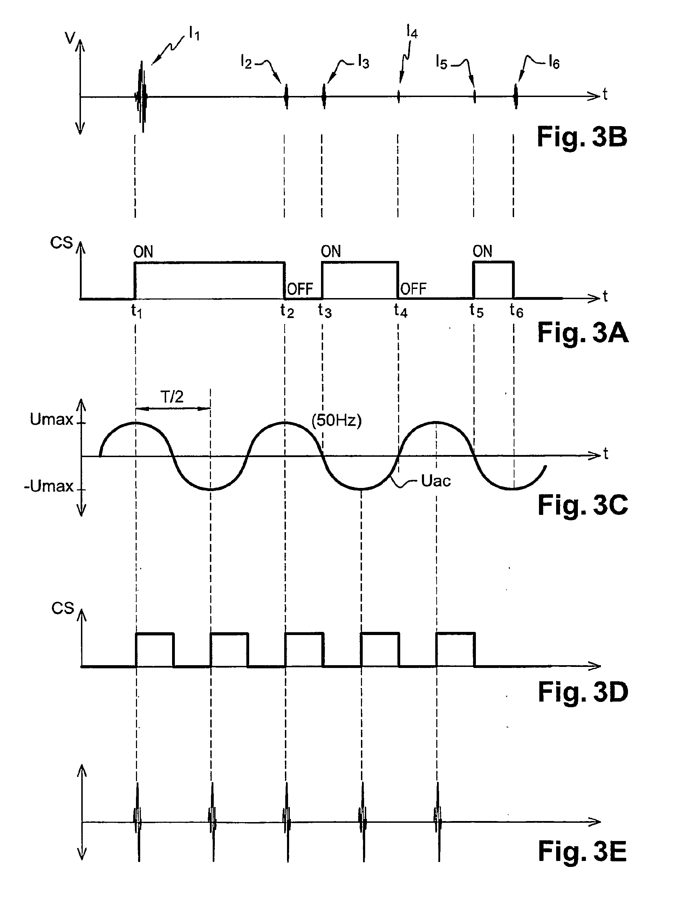

Le document US 2003/0156014 décrit un procédé de transmission de données sur un réseau électrique utilisant une pluralité de fréquences sous-porteuses (Cf. paragraphe 011) qui sont injectées dans le réseau au moyen d'un circuit de couplage (Cf. 121, fig. 3).

Le document US 2002/0024423 décrit un procédé d'injection sur un réseau électrique de données codées au moyen d'un code pseudo bruité qui est modulé au moyen d'un train d'impulsions d'énergie électrique sans utiliser une porteuse sinusoïdale. Ce procédé repose, comme les précédents, sur l'injection d'énergie dans le réseau électrique et non sur l'utilisation d'impulsions parasites naturelles.

Le document US 3 714 451 décrit également l'injection d'impulsions d'énergie dans un réseau électrique, par décharge d'un condensateur (Cf. 25a figure 2, figures 4, 5, 7, revendication 1).

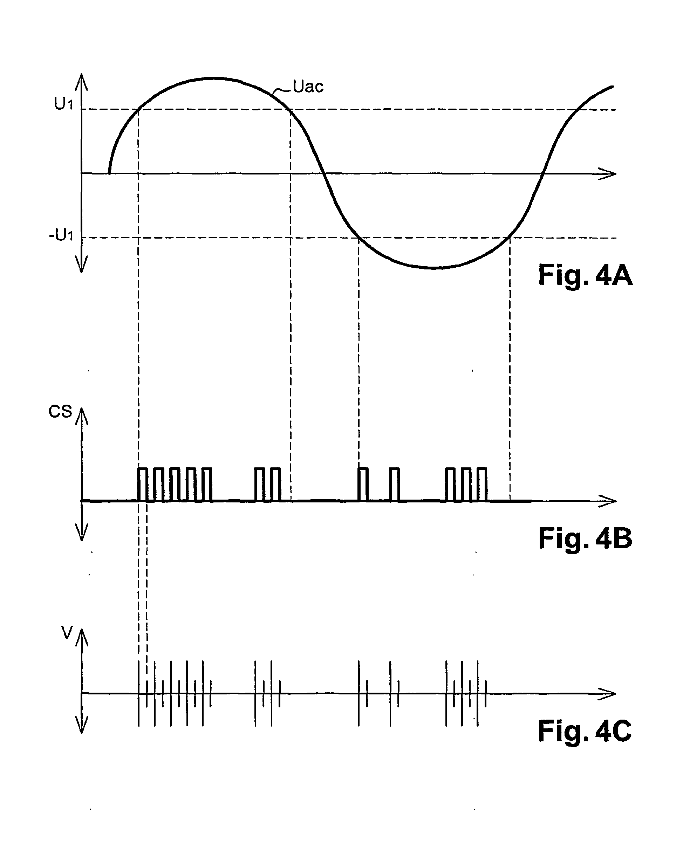

Le document WO 00 /26679 décrit un procédé de détection de la fermeture d'un interrupteur dans lequel on injecte des pics de courant dans une branche d'un réseau (Cf. figure 4) contrôlée par l'interrupteur. L'injection de courant est assurée par un circuit (Cf. figures 1A ou 1B) qui décharge cycliquement un condensateur (Cf. 170 ou 260). Les impulsions de courant sont de courte durée afin de limiter l'apparition, dans des branches de réseau voisines, de pics de courants induits. Les pics de courant induits sont ainsi de faible amplitude et ne perturbent pas la détection du pic de courant principal. La détection du pic de courant principal est assurée par un détecteur (Cf. fig. 2) qui comporte une bobine (L1) permettant de détecter le pic de courant par induction. Un amplificateur couplé à la bobine alimente électriquement un avertisseur sonore (351) qui émet un signal sonore lorsque l'utilisateur se rapproche de la branche où les pics de courant sont injectés.

Enfin, le document US 4 982 175 décrit un système de télémétrie qui injecte sur un réseau électrique des impulsions (Cf. 32, figure 3) provoquées par la décharge d'un condensateur (Cf. 26, figure 2). Ces impulsions ne sont pas des impulsions parasites haute fréquence au sens de l'invention et sont détectées par induction au moyen de bobines (Cf. 41a à 42b, figure 6).

Ainsi, la présente invention prévoit un procédé de transmission d'une information par l'intermédiaire d'un réseau de distribution d'électricité véhiculant une tension, comprenant les étapes suivantes : relier un élément électrique au réseau par l'intermédiaire d'un moyen interrupteur, l'élément électrique émettant naturellement une impulsion parasite haute fréquence lorsqu'il est connecté au réseau par la fermeture du moyen interrupteur et/ou lorsqu'il est déconnecté du réseau par l'ouverture du moyen interrupteur, appliquer au moyen interrupteur un signal de contrôle de forme déterminée de manière que l'élément électrique émette une suite prédéterminée d'impulsions parasites haute fréquence au rythme du signal de contrôle, et détecter les impulsions parasites haute fréquence et reconstituer le signal de contrôle.

Selon un mode de réalisation, le moyen interrupteur est piloté par un signal de contrôle porteur de données, de sorte que des impulsions parasites haute fréquence porteuses de données sont émises au rythme du signal de contrôle.

Selon un mode de réalisation, le signal de contrôle est un signal codé.

Selon un mode de réalisation, le réseau de distribution d'électricité véhicule une tension alternative et le signal de contrôle est synchronisé à la forme d'onde de la tension alternative, de manière que l'interrupteur ne soit fermé que lorsque la tension alternative se trouve au voisinage de sa valeur crête.

Selon un mode de réalisation, la tension alternative est considérée comme au voisinage de sa valeur crête lorsqu'elle présente une amplitude au moins égale à 50% de sa valeur crête.

Selon un mode de réalisation, le signal de contrôle est synchronisé à la forme d'onde de la tension alternative de manière que l'interrupteur ne soit ouvert que lorsque la tension alternative se trouve au voisinage de zéro.

Selon un mode de réalisation, le signal de contrôle est composé d'impulsions de fermeture/ouverture du moyen interrupteur de durée constante, chaque impulsion de fermeture/ouverture comprenant un front montant et/ou un niveau haut provoquant un changement dans l'état ouvert ou fermé de l'interrupteur et un front descendant et/ou un niveau bas provoquant un changement inverse de l'état de l'interrupteur.

Selon un mode de réalisation, le signal de contrôle comprend des impulsions de fermeture/ouverture d'une durée inférieure au 1/8ième de la période de la tension alternative.

Selon un mode de réalisation, l'élément électrique est un condensateur, une résistance, une diode électroluminescente ou une combinaison d'au moins deux de ces éléments.

Selon un mode de réalisation, des impulsions parasites sont neutralisées, rejetées ou ignorées, et ne sont pas prises en compte pour reconstituer le signal de contrôle.

Selon un mode de réalisation, la détection des impulsions parasites comprend la production d'un signal image de la tension véhiculée par le réseau de distribution d'électricité, le filtrage passe haut du signal image, l'échantillonnage du signal image selon une fenêtre d'échantillonnage déterminée, pour obtenir des échantillons numériques du signal image, et l'analyse des échantillons du signal image.

L'invention concerne également un procédé de mesure à distance de la consommation électrique locale d'un appareil électrique connecté à un réseau de distribution d'électricité véhiculant une tension déterminée, comprenant une étape de mesure de la consommation électrique du dispositif au moyen d'un capteur de courant embarqué, une étape d'émission et une étape de réception d'une information relative à la consommation électrique mesurée mise en oeuvre conformément au procédé selon l'invention.

L'invention concerne également un procédé d'identification d'un appareil électrique connecté à un réseau de distribution d'électricité véhiculant une tension déterminée, comprenant une étape d'émission d'une suite d'impulsions parasites haute fréquence formant un code d'identification de l'appareil, mise en oeuvre conformément au procédé selon l'invention.

Selon un mode de réalisation, l'appareil électrique est un disjoncteur; et l'émission du code d'identification n'est déclenchée que lorsque le disjoncteur a disjoncté.

L'invention concerne également un dispositif d'émission et de réception d'une information via un réseau de distribution d'électricité véhiculant une tension, comprenant :
- un dispositif d'émission d'impulsions sur le réseau comprenant un élément électrique et un moyen interrupteur pour relier l'élément électrique au réseau de distribution d'électricité, l'élément électrique émettant naturellement des impulsions parasites haute fréquence lorsqu'il est connecté au réseau par la fermeture du moyen interrupteur et/ou lorsqu'il est déconnecté du réseau par l'ouverture du moyen interrupteur, et des moyens pour appliquer au moyen interrupteur un signal de contrôle de forme déterminée de manière que l'élément électrique émette une suite d'impulsions parasites haute fréquence au rythme du signal de contrôle, et
- un dispositif de réception des impulsions parasites haute fréquence comprenant des moyens de reconstitution du signal de contrôle.

Selon un mode de réalisation, le dispositif comprend des moyens pour fournir au moyen interrupteur un signal de contrôle porteur de données.

Selon un mode de réalisation, le dispositif comprend des moyens pour fournir au moyen interrupteur un signal de contrôle codé.

Selon un mode de réalisation prévu pour un réseau de distribution d'électricité véhiculant une tension alternative, le dispositif de réception comprend des moyens de surveillance de l'amplitude de la tension alternative, fournissant un signal d'autorisation d'émission d'impulsions ayant une valeur déterminée lorsque la tension alternative se trouve au voisinage de sa valeur crête, et des moyens pour ne fermer l'interrupteur que lorsque le signal d'autorisation d'émission d'impulsions présente la valeur déterminée.

Selon un mode de réalisation, les moyens de surveillance fournissent un signal d'autorisation d'émission d'impulsions ayant la valeur déterminée lorsque l'amplitude de la tension alternative vaut au moins 50% de sa valeur crête.

Selon un mode de réalisation, les moyens de surveillance comprennent un redresseur fournissant une tension redressée simple ou double alternance dont l'amplitude est représentative de l'amplitude de la tension alternative, et un comparateur recevant sur une entrée une tension de référence et sur une autre entrée la tension redressée, fournissant le signal d'autorisation d'émission de données.

Selon un mode de réalisation, les moyens pour fournir le signal de contrôle fournissent un signal de contrôle composé d'impulsions de fermeture/ouverture du moyen interrupteur de durée constante, chaque impulsion comprenant un front montant et/ou un niveau haut provoquant un changement dans l'état ouvert ou fermé de l'interrupteur et un front descendant et/ou un niveau bas provoquant un changement inverse de l'état de l'interrupteur.

Selon un mode de réalisation, les moyens pour fournir le signal de contrôle fournissent des impulsions de fermeture/ouverture d'une durée au moins inférieure au 1/8ième de la période de la tension alternative.

Selon un mode de réalisation, l'élément électrique est un condensateur, une résistance, une diode électroluminescente ou une combinaison d'au moins deux de ces éléments.

Selon un mode de réalisation, le moyen interrupteur est un triac, un transistor MOS ou un relais.

Selon un mode de réalisation, le signal de contrôle est fourni par un microcontrôleur ou un microprocesseur.

Selon un mode de réalisation, le dispositif d'émission d'impulsions comprend des moyens de mesure de courant et est agencé pour émettre sous forme d'impulsions parasites haute fréquence une information relative à un courant mesuré.

Selon un mode de réalisation, le dispositif de réception comprend des moyens pour filtrer, rejeter ou ignorer des impulsions parasites afin de ne pas prendre en compte de telles impulsions dans la reconstitution du signal de contrôle.

Selon un mode de réalisation prévu pour un réseau de distribution d'électricité véhiculant une tension alternative, le dispositif de réception comprend des moyens pour fournir un signal image de la tension alternative, et des moyens de filtrage passe-haut du signal image, pour en extraire les impulsions parasites haute fréquence.

Selon un mode de réalisation, le dispositif de réception comprend une antenne pour détecter les impulsions parasites haute fréquence en utilisant une composante électromagnétique des impulsions parasites.

Selon un mode de réalisation, le dispositif de réception comprend des moyens d'échantillonnage du signal reçu, et des moyens d'analyse des échantillons du signal reçu, pour détecter la présence d'impulsions parasites haute fréquence.

L'invention concerne également un dispositif disjoncteur présentant un état fermé et un état ouvert, et un dispositif d'émission d'impulsions selon l'invention, pour émettre une suite d'impulsions déterminée lorsque le dispositif disjoncteur est dans l'état ouvert.

Selon un mode de réalisation, le dispositif comprend un interrupteur témoin qui bascule de l'état ouvert à l'état fermé lorsque le dispositif disjoncteur bascule de l'état fermé à l'état ouvert, et tout ou partie du dispositif d'émission d'impulsions est alimenté électriquement par l'intermédiaire de l'interrupteur témoin, de sorte que le dispositif d'émission d'impulsions est inactif tant que le disjoncteur est dans l'état fermé.

Ces objets, caractéristiques et avantages ainsi que d'autres de la présente invention seront exposés plus en détail dans la description suivante du procédé selon l'invention et de divers exemples d'application décrits sous forme de dispositifs mettant en oeuvre le procédé, faite à titre non limitatif en relation avec les figures jointes parmi lesquelles :
- la figure 1 représente l'aspect d'une impulsion parasite haute fréquence,
- la figure 2 représente schématiquement un dispositif mettant en oeuvre le procédé selon l'invention,
- la figure 3A, 3B sont des chronogrammes illustrant de façon générale le procédé selon l'invention,
- la figure 3C représente la forme d'onde d'une tension distribuée par un réseau de distribution d'électricité,
- les figures 3D, 3E sont des chronogrammes de signaux illustrant un premier mode de réalisation du procédé selon l'invention,
- la figure 4A représente avec une échelle temporelle dilatée la forme d'onde d'une tension distribuée par un réseau de distribution d'électricité,
- les figures 4B, 4C sont des chronogrammes de signaux illustrant un second mode de réalisation du procédé selon l'invention,
- la figure 5 est le schéma électrique d'un exemple de réalisation d'un dispositif d'émission d'impulsions selon l'invention,
- la figure 6 représente sous forme de blocs un autre exemple de réalisation d'un dispositif d'émission d'impulsions selon l'invention, et
- la figure 7 représente sous forme de blocs un disjoncteur selon l'invention.

La figure 1 représente l'aspect d'une impulsion parasite I émise naturellement par un élément électrique lors de sa mise sous tension. Une telle impulsion parasite est indépendante de la consommation électrique de l'élément électrique et prend la forme d'un train d'ondes alternatif haute fréquence, typiquement d'une fréquence de l'ordre de 20 MHz. La durée de cette impulsion parasite est de quelques centaines de nanosecondes, typiquement 250 nanosecondes. Son amplitude U peut aller de la dizaine de millivolt jusqu'à quelques Volt (sous une tension de 220 Volt) selon la composante réactive de l'élément et la puissance qu'il absorbe. A la réception, en raison des limitations de la bande passante des canaux de mesure (appareillage de mesure et réseau de distribution), les impulsions recueillies sont plus larges et de l'ordre de la dizaine de microsecondes, soit un étalement par un facteur 40 de l'impulsion initiale.

Comme cela est indiqué plus haut, la présente invention propose de contrôler l'émission, par un élément électrique, d'impulsions parasites haute fréquence, pour obtenir une suite d'impulsions ayant un profil recherché, au lieu de reproduire artificiellement de telles impulsions.

La figure 2 illustre le procédé selon l'invention. Un élément électrique 1 est relié par l'intermédiaire d'un interrupteur 2 à un réseau 3 de distribution d'électricité véhiculant une tension alternative Uac. Le réseau 3 est ici monophasé et l'élément électrique 1 est relié au fil de phase (PH) et au fil de neutre (NL) du réseau, l'interrupteur 2 étant interposé entre le fil de phase et la borne correspondante de l'élément électrique. L'interrupteur 2 comporte une borne de contrôle à laquelle est appliqué un signal de contrôle CS assurant le contrôle de la fermeture et de l'ouverture de l'interrupteur. L'interrupteur 2 est de tout type approprié, par exemple un interrupteur monostable de type normalement ouvert (transistor MOS ou bipolaire, relais monostable...) ou un interrupteur bistable (triac, relais bistable...).

L'élément 1 peut être tout type d'élément électrique produisant des impulsions parasites de forme souhaitée (durée, amplitude,...), par exemple une ampoule électrique, une diode électroluminescente (diode DEL), un condensateur, une résistance de forte valeur ou une combinaison de ces éléments. L'élément électrique présente de préférence une forte impédance pour éviter l'apparition sur le réseau d'un courant de commutation élevé. L'élément électrique est par exemple un condensateur 250V de faible valeur (C) ayant une impédance Z élevée (Z=1/2πFC) à la fréquence (F) de la tension Uac, généralement 50 ou 60 Hz.

Le signal de contrôle CS est un signal à deux états "1" et "0", le "1" correspondant à une tension de contrôle déterminée et le "0" correspondant à une autre tension de contrôle déterminée, pouvant être le potentiel de masse. Par convention, on considère que l'interrupteur est fermé (passant) lorsque le signal CS est à 1 (interrupteur monostable) ou lorsque le signal CS passe de 0 à 1 (interrupteur bistable) et que l'interrupteur est ouvert (non passant) lorsque le signal CS est à 0 ou passe de 1 à 0. Comme cela sera vu plus loin, le signal CS est susceptible d'être appliqué directement à la borne de contrôle de l'interrupteur ou par l'intermédiaire d'un étage d'adaptation. Le signal CS représente ainsi, au sens de l'invention, le signal de contrôle logique de l'interrupteur. Il peut constituer le signal de contrôle primaire de l'interrupteur, c'est-à-dire le signal qui est effectivement appliqué à la borne de contrôle de l'interrupteur, s'il est compatible avec les caractéristiques électriques de cette borne de contrôle.

En résumé, le procédé selon l'invention est basé sur l'émission d'impulsions haute fréquence désignées ici et dans les revendications comme étant des impulsions "parasites", pour les distinguer d'impulsions produites artificiellement. Toutefois, le terme "parasite" ne signifie pas que le procédé selon l'invention est producteur de parasites et se trouve de ce fait incompatible avec les législations visant à réglementer la pollution sur les réseaux électriques. Au contraire, en raison de la durée très brève des impulsions parasites le procédé selon l'invention est moins "intrusif" et moins perturbateur que les procédés classiques basés sur l'injection dans le réseau électrique d'un signal de porteuse ou l'injection d'impulsions de décharge de condensateur.

Les figures 3A, 3B, 3C illustrent plus en détail le procédé selon l'invention. La figure 3A représente un exemple de forme quelconque de signal CS et la figure 3B représente l'amplitude, en Volt, des impulsions parasites haute fréquence produites sur le réseau 3. La figure 3C représente la forme d'onde de la tension Uac au moment où les impulsions parasites sont émises. A chaque passage de l'état 0 à l'état 1 du signal CS, l'interrupteur 2 devient passant (ON), l'élément électrique 1 reçoit la tension Uac et une impulsion parasite de fermeture I1, I3, I5 (ou impulsion de connexion) est émise. A chaque passage de l'état 1 à l'état 0 du signal CS, l'interrupteur 2 passe dans l'état ouvert (OFF), l'élément 1 est déconnecté du réseau et une impulsion parasite d'ouverture I2, I4, I6 (ou impulsion de déconnexion) est émise.

En observant conjointement les figure 3B et 3C, il apparaît que l'amplitude des impulsions parasites n'est pas constante et dépend, notamment, des moments où ces impulsions sont émises. Plus particulièrement, les observations expérimentales suivantes ont été faites :
- observation N°1 : l'amplitude des impulsions parasites de fermeture ou d'ouverture dépend de l'amplitude de la tension Uac au moment où intervient la fermeture ou l'ouverture de l'interrupteur,
- observation N°2 : dans des conditions d'émission similaires, certaines impulsions parasites, ici les impulsions parasites d'ouverture (de déconnexion), peuvent présenter une amplitude inférieure à celle des impulsions parasites de fermeture et n'excédant pas 10% de l'amplitude des impulsions parasites de fermeture.

Ainsi, conformément à l'observation N°1, il apparaît en figure 3B que l'impulsion parasite de fermeture I1 est maximale car elle est émise à un instant t1 où la tension Uac est égale à sa valeur crête Umax (une impulsion parasite de même amplitude serait obtenue avec la valeur crête -Umax). Par ailleurs, les impulsions parasites de fermeture I3, I5 sont émises à des instants t3, t5 où la tension Uac présente une amplitude faible, et présentent une amplitude très inférieure à celle de l'impulsion I1. De même l'impulsion parasite d'ouverture I4 est émise à un instant t4 où la tension Uac est inférieure à sa valeur crête Umax ou -Umax, et présente une amplitude inférieure à celle de l'impulsion parasite d'ouverture I2. Conformément à l'observation N° 2, il apparaît que l'impulsion parasite d'ouverture I2, bien qu'émise à un instant t2 où la tension Uac est maximale (soit dans les mêmes conditions) présente une amplitude nettement inférieure à celle de l'impulsion parasite I1. Enfin, l'impulsion parasite d'ouverture I6 est émise à un instant t6 où la tension Uac est maximale (-Umax) et présente une amplitude supérieure à celles des impulsions parasites de fermeture I3, I5 qui sont émises dans des conditions défavorables, et ce malgré le fait que ces dernières seraient d'une amplitude supérieure si elles étaient émises dans les même conditions.

Dans un mode de réalisation de l'invention reposant sur ces observations, les règles suivantes sont appliquées :
1) les impulsions parasites d'ouverture ne sont pas considérées ici comme "exploitables", ayant une amplitude trop faible relativement aux impulsions parasites de fermeture. Ainsi, ces impulsions sont neutralisées à l'émission, ou rejetées à la réception d'une manière décrite plus loin.
2) les impulsions parasites de fermeture sont émises lorsque la tension Uac est proche de la valeur maximale, c'est-à-dire lorsque la tension Uac présente une amplitude supérieure ou égale à x% de la valeur Umax, x étant un paramètre à définir expérimentalement et de préférence au moins égal à 50.

Les figures 3D, 3E illustrent un premier mode de réalisation du procédé dans lequel les impulsions parasites d'ouverture sont neutralisées à l'émission. La figure 3D représente la forme du signal CS et la figure 3E représente l'amplitude des impulsions obtenues. Le signal CS est synchronisé à la forme d'onde de la tension Uac, représentée en figure 3C. Plus particulièrement, le signal CS passe à 1 lorsque la tension Uac est égale à Umax ou -Umax et passe à 0 lorsque la tension Uac est nulle. En d'autres termes, l'interrupteur 2 passe de l'état fermé à l'état ouvert lorsque la tension Uac est nulle et les impulsions parasites d'ouverture ne sont jamais émises, comme cela apparaît en figure 3E. Par contre, l'amplitude des impulsions parasites de fermeture est maximale puisque l'interrupteur n'est fermé qu'aux instants où la tension Uac est maximale.

Le profil de signal CS représenté en figure 3D ne constitue bien entendu qu'un gabarit déterminant les instants autorisés de fermeture et d'ouverture de l'interrupteur 2. Ainsi, diverses séries d'impulsions ayant chacun un profil propre peuvent être émises, chaque profil pouvant être affecté à l'identification d'un appareil électrique déterminé, comme cela était envisagé par EP 1 136 829 mais en utilisant des impulsions de synthèse.

Selon un aspect de l'invention, ce gabarit est utilisé pour transmettre des données. Par exemple, comme illustré en figure 2, des données DTx à émettre, éventuellement sous forme codée, sont appliquées à un circuit 4 qui fournit le signal de contrôle CS tout en surveillant la tension Uac. L'envoi de données peut se faire bit à bit ou sous forme de trame comprenant par exemple un bit de start et 8 bits de données, et éventuellement un champ de signature, par exemple un bit de parité. En l'absence de codage, une fermeture de l'interrupteur 2 (soit l'émission d'une impulsion parasite) correspond à l'envoi d'un bit à 1, tandis que l'absence de fermeture de l'interrupteur au moment imposé par le gabarit, soit une absence d'impulsion parasite, correspond à l'envoi d'un bit à 0.

Dans un réseau 50Hz, la période T de la tension Uac est de 20 ms, de sorte que 100 impulsions parasites (soit 100 bits non codés) peuvent être envoyées en une seconde. Bien que ce débit d'impulsions soit lent, il est suffisant pour certaines applications d'identification ou de transmission de données, notamment une application à la gestion d'un parc de lampadaires publics décrite plus loin.

Un second mode de réalisation du procédé est prévu pour l'envoi de données ou de trains d'impulsions avec un débit plus élevé. Ce mode de réalisation est illustré par les figures 4A, 4B, 4C. Ici, les impulsions parasites de fermeture ne sont pas neutralisées à l'émission et sont ignorées à la réception, grâce à un réglage adéquat d'un seuil de détection. Pour déterminer les instants d'autorisation d'émission des impulsions parasites, un seuil U1 proche de la valeur crête Umax est choisi, par exemple un seuil égal à 0,66 Umax. Comme représenté en figure 4A, ce seuil permet de définir deux fenêtres temporelles d'autorisation d'émission TW1, TW2 à chaque demi-période T/2 de la tension Uac. La fenêtre TW1 englobe les valeurs de la tension Uac positives et supérieures à U1 et la fenêtre TW2 englobe les valeurs de la tension Uac négatives et inférieures à -U1 (soit supérieures à U1 en valeur absolue). La figure 4B représente le gabarit du signal de contrôle CS. Celui-ci comprend des trains d'impulsions de fermeture/ouverture qui sont appliqués à l'interrupteur 2 à l'intérieur de chaque fenêtre temporelle TW1, TW2. Comme cela apparaît en figure 4C, chaque impulsion de fermeture/ouverture provoque l'émission sur le réseau de deux impulsions parasites haute fréquence, soit une impulsion parasite de fermeture lors du front montant de l'impulsion de fermeture/ouverture et une impulsion parasite d'ouverture lors du front descendant de l'impulsion de fermeture/ouverture. Comme indiqué plus haut, les impulsions parasites d'ouverture sont d'une amplitude très inférieure à celle des impulsions parasites de fermeture et sont destinées à être filtrées à la réception.

Avec une tension Uac de fréquence 50 Hz, la durée des fenêtres TW1, TW2 est de l'ordre de 6 à 7 ms et le nombre d'impulsions de fermeture/ouverture pouvant être envoyé est élevé. Ainsi, si chaque impulsion de fermeture/ouverture provoque l'émission de deux impulsions parasites haute fréquence d'une durée de l'ordre de 10 microsecondes chacune (largeur d'impulsion à la réception, signal utile), la durée minimale de chaque impulsion de fermeture/ouverture doit au moins être égale à deux fois la durée des impulsions parasites, soit de l'ordre de 10 à 20 microsecondes. Dans ces conditions, en choisissant cette durée minimale d'impulsion en tant que gabarit, et sans tenir compte des limitations éventuelles de l'interrupteur en terme de fréquence de commutation, chaque fenêtre temporelle peut contenir environ 300 impulsions de fermeture/ouverture et offre ainsi un débit de données élevé relativement au premier mode de réalisation du procédé de l'invention, de l'ordre de 30000 impulsions par seconde.

Comme précédemment, les données peuvent être envoyées sous forme brute, un bit correspondant alors à une impulsion, ou sous forme codée par tout protocole de codage approprié, un bit correspondant alors à plusieurs impulsions. Les données codées ou non peuvent être envoyées sous forme de bits individuels ou sous forme de trame comprenant un champ de début de trame, un champ de données, et éventuellement un champ de fin de trame pouvant comprendre un champ de vérification de type CRC ou de parité.

Il apparaîtra clairement à l'homme de l'art que ce procédé est susceptible de diverses variantes de réalisation et applications. Par exemple, l'émission des impulsions parasites haute fréquence peut n'être prévue qu'une fois par période au lieu de deux fois par période, par exemple lorsque la tension Uac est égale à +Umax (premier mode de réalisation) ou est supérieure à +U1 (second mode de réalisation).

La figure 2 représente également, de façon schématique, deux exemples de réalisation de détecteurs d'impulsions 10, 15 selon l'invention.

Le détecteur 10 est un dispositif à réception inductive dont le principe de fonctionnement a déjà été décrit dans EP 1 136 829. Il comprend un transformateur d'entrée pour extraire de la tension Uac un signal image qui est analysé pour détecter les impulsions parasites haute fréquence. Le transformateur peut être simplement formé par une bobine 11 agencée autour du fil de phase (PH) du réseau, à un point source de la distribution du courant, par exemple à proximité d'un compteur électrique. La bobine fournit le signal image qui est appliqué à un filtre passe haut 12 pour supprimer sa composante alternative basse fréquence. La sortie du filtre est appliquée à un convertisseur analogique numérique échantillonneur-bloqueur 13 ("sample hold AD converter") qui fournit des échantillons numériques de la tension Uac filtrée, en synchronisation avec une période d'échantillonnage définissant une fenêtre d'observation. Le choix de la période d'échantillonnage et de la durée de la fenêtre d'observation est fonction de la période d'émission des impulsions parasites haute fréquence, soit la période entre deux impulsions de fermeture/ouverture. Si les impulsions parasites sont émises avec une fréquence élevée, conformément au second mode de réalisation du procédé de l'invention, la fenêtre d'observation est choisie suffisamment courte pour l'obtention d'une finesse d'analyse permettant de différencier les impulsions au sein des trains d'impulsions émis. L'analyse des échantillons de la tension Uac est assurée par un circuit d'analyse 14, généralement un circuit logique spécifique, qui analyse l'amplitude des échantillons reçus et détecte les impulsions d'une amplitude supérieure au seuil de réjection des impulsions parasites de fermeture, pour ne retenir que les impulsions parasites d'ouverture. Le circuit 14 reconstitue ainsi le signal de contrôle CS, et en déduit également les données DTx quand le signal CS est porteur de données. Les données DTx, si elles sont reçues sous forme codée, peuvent également être décodées par le circuit 14.

Le détecteur 15 est un dispositif sans contact comportant une antenne 16, un amplificateur d'antenne 17 et un filtre passe-haut 18 pour éliminer les signaux de fréquence inférieure à celle des impulsions à détecter. En sus de ces éléments sont prévus, comme précédemment, un convertisseur analogique numérique échantillonneur-bloqueur 13 et un circuit d'analyse 14. Ce mode de réalisation d'un détecteur d'impulsions selon l'invention se base sur le fait que les impulsions parasites haute fréquence se retrouvent aussi bien en tant qu'impulsions électriques sur le réseau qu'en tant qu'impulsions électromagnétiques pouvant être détectées de la même manière que tout signal radiofréquence. Le détecteur 15 est de préférence agencé à proximité des équipements émetteurs d'impulsions, par exemple dans les locaux où sont installés les équipements.

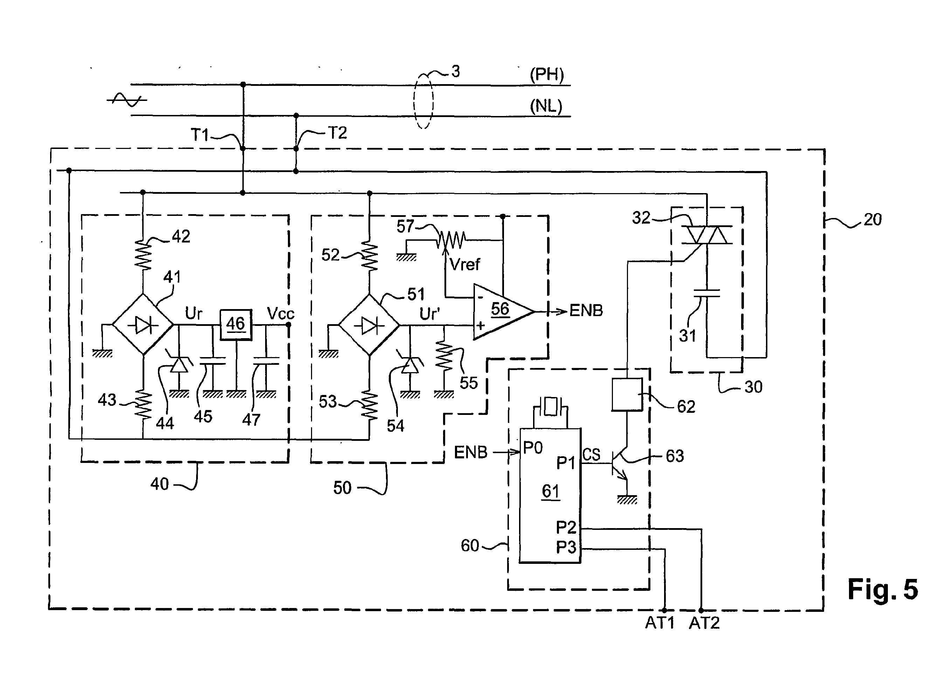

La figure 5 représente un mode de réalisation simple et peu coûteux d'un dispositif 20 d'émission d'impulsions selon l'invention, destiné à être embarqué dans des appareils ou dans des équipements électriques.

Le dispositif 20 comprend deux bornes T1, T2 de connexion au réseau de distribution d'électricité 3, un circuit de commutation 30, un circuit d'alimentation électrique 40, un circuit 50 de surveillance de la tension alternative Uac et un circuit de contrôle 60. La borne T1 est connectée au fil de phase (PH) et la borne T2 connectée au fil de neutre (NL) du réseau 3. Conformément au procédé de l'invention, le circuit de commutation 30 comprend un élément électrique 31, ici un condensateur, et un interrupteur 32. L'interrupteur 32 est par exemple un triac ou un transistor MOS (un triac étant représenté sur la figure 5). L'interrupteur 32 a une borne connectée à la borne T1, une autre borne connectée à une borne du condensateur 31, et une borne de contrôle (gâchette du triac ou grille du transistor MOS) pilotée par le circuit de contrôle 60. L'autre borne du condensateur 31 est connectée à la borne T2.

Le circuit d'alimentation 40 comprend un pont redresseur 41 à diodes ayant deux bornes d'entrée connectées aux bornes I1, I2 par l'intermédiaire de résistances 42, 43, une borne reliée à la masse et une borne de sortie fournissant une tension redressée double alternance Ur. La tension Ur est appliquée sur une entrée d'un bloc régulateur 46 qui est reliée à la masse par l'intermédiaire d'une diode 44 d'écrêtage des surtensions et d'un condensateur de lissage 45. La sortie du bloc régulateur 46 est reliée à un condensateur de stabilisation 47 et fournit une tension Vcc d'alimentation des circuits 50, 60.

Le circuit de surveillance 50 comprend un pont redresseur 51 à diodes ayant deux bornes d'entrée connectées aux bornes I1, I2 par l'intermédiaire de résistances 52, 53, respectivement, une borne reliée à la masse et une borne de sortie fournissant une tension redressée double alternance Ur'. La tension redressée Ur' est appliquée sur l'entrée positive d'un amplificateur différentiel 56 qui est reliée à la masse par l'intermédiaire d'une diode 54 d'écrêtage des surtensions et d'une résistance de charge 55. L'entrée négative de l'amplificateur 56 reçoit une tension de référence Vref fournie par le point milieu d'un potentiomètre 57 dont l'anode reçoit la tension Vcc et dont la cathode est à la masse. L'amplificateur différentiel 56, fonctionnant ici en comparateur, fournit un signal ENB ("Enable") qui est à 1 (Vcc) lorsque la tension redressée double alternance Ur' est supérieure à la tension de référence Vref, et est à 0 (masse) dans le cas contraire. Le potentiomètre 57 permet de régler la tension Vref afin de définir la largeur des fenêtres temporelles d'autorisation d'émission TW1, TW2. En augmentant la tension Vref, la largeur des fenêtres diminue et l'on obtient finalement deux instants d'autorisation correspondant à Uac=Umax et Uac=-Umax, correspondant à la mise en oeuvre du premier mode de réalisation du procédé selon l'invention (soit une impulsion par demi-période de la tension Uac). A noter que le circuit de surveillance 50 peut ne comprendre qu'un redresseur simple alternance s'il est prévu que des impulsions ne sont émises que sur l'une des deux demi-périodes de la tension Uac.

Le circuit 60 fournit le signal de contrôle CS appliqué à la borne de contrôle de l'interrupteur 32. Le circuit 60 comprend un microcontrôleur 61 à bas coût, incorporant sur la même microplaquette de silicium un microprocesseur et ses ports d'entrée/sortie P0, P1, P2, P3..., une mémoire programme, des mémoires de données, un oscillateur à quartz... Le port P0 reçoit le signal ENB, le port P1 fournit le signal de contrôle CS, et les ports P2 P3 sont, de façon optionnelle, utilisés en tant que ports de communication du microcontrôleur pour des opérations de test, de maintenance, de programmation,... et sont reliés à des bornes auxiliaires AT1, AT2 du dispositif 20.

Le microcontrôleur détecte le passage à 1 du signal ENB par scrutation (polling) du port P0 ou par interruption déclarée sur ce port. Le port P1 pilote l'interrupteur 32 par l'intermédiaire d'un étage adaptateur comprenant un bloc de commande 62 et un transistor 63. Le bloc de commande 62 a une sortie connectée à la borne de contrôle de l'interrupteur 32 et une entrée connectée au collecteur du transistor 63, dont l'émetteur est connecté à la masse et dont la base reçoit le signal de contrôle CS.

Le dispositif 20, une fois embarqué sur un appareil électrique, est utilisable pour transmettre des données ou, plus simplement, pour émettre une suite d'impulsions non porteuse de données, ayant un profil prédéterminé invariable, servant par exemple à l'identification de l'appareil électrique. Dans ce dernier cas, le circuit 60 peut être un circuit logique d'une architecture rudimentaire, comprenant une entrée de synchronisation recevant le signal ENB et fournissant le signal de contrôle CS. La prévision d'un microcontrôleur ou microprocesseur permet de mettre en oeuvre des applications plus complexes nécessitant de traiter et de transmettre des données, comme cela apparaîtra dans les exemples d'application décrits plus loin.

Le dispositif 20 peut ainsi faire l'objet de diverses applications. Un exemple d'application est le contrôle de lampadaires publics dans une agglomération. A cet effet, chaque lampadaire est équipé d'un tel dispositif et envoie cycliquement une information concernant son état allumé ou éteint. Cette information peut être envoyée à faible débit conformément au premier mode de réalisation du procédé de l'invention, puisqu'elle ne présente aucun caractère d'urgence et peut être traitée sur des périodes de temps de plusieurs minutes. Avec un investissement raisonnable, des centaines de lampadaires peuvent être équipés de dispositifs selon l'invention. En accordant à chaque lampadaire une seconde toutes les minutes pour émettre des impulsions représentatives de l'état du lampadaire, 60 lampadaires peuvent émettre des informations en une minute. Une unité de réception agencée en un point source du réseau de distribution d'électricité urbaine ou à un noeud de dérivation, est suffisante pour recevoir les informations envoyées par une pluralité de lampadaires.

Le dispositif d'émission d'impulsions selon l'invention peut par ailleurs faire l'objet de diverses variantes de réalisation en fonction des applications visées.

La figure 6 représente un dispositif 20' qui comprend, en sus des circuits 30, 40, 50 et 60 qui viennent d'être décrits, un capteur de courant 70 relié à un circuit de mesure 71. Le circuit de mesure 71 envoi au circuit de contrôle 60 des données relatives à des mesures de courant effectuées au moyen du capteur 70. Le microcontrôleur du dispositif 60 analyse les résultats des mesures et décide de les envoyer ou non en fonction de ce qui est prévu dans le programme application chargé dans sa mémoire programme. Ce programme peut par exemple prévoir que le microcontrôleur envoie sur le réseau une information relative au courant mesuré uniquement lorsque celui-ci passe de 0 à une valeur non nulle, puis passe d'une tranche de consommation à une autre, par exemple de la tranche allant de 0 à 1 A à la tranche allant de 1 à 2 A, de la tranche allant de 1 à 2 A à la tranche allant de 2 à 3 A, etc. Cette information peut prendre la forme d'un mot de huit bits (octet) présentant une première valeur lorsque le courant mesuré passe de 0 à une valeur non nulle, puis une deuxième valeur lorsque le courant passe de la tranche 0-1 A à la tranche 1-2 A, etc..

Le dispositif 20' peut être agencé dans une prise électrique, notamment une prise gigogne utilisée pour alimenter électriquement un ou plusieurs appareils, ou être embarqué dans un appareil électrique, afin de mesurer le courant traversant la prise électrique ou le courant consommé par l'appareil dans lequel il est embarqué. Une telle application permet de perfectionner le procédé de mesure de la consommation électrique d'appareils électriques décrit par EP 1 136 829. En effet, lorsque le courant passe de 0 à une valeur non nulle, l'émission du premier octet permet d'identifier sur le réseau l'appareil ou le groupe d'appareil qui est mis sous tension. Ensuite, l'émission d'octets en relation avec le changement de tranche de consommation permet de confirmer les mesures de consommation et de localisation effectuées sur le réseau de la manière proposée par EP 1 136 829.

On décrira maintenant encore un autre exemple d'application du procédé et du dispositif selon l'invention.

De nombreuses installations industrielles comprennent des disjoncteurs regroupés dans des armoires électriques, dont l'état fermé (enclenché) ou ouvert (disjoncté) doit être surveillé. A cet effet, on a développé dans l'état de la technique des disjoncteurs équipés d'un interrupteur témoin qui, par le biais d'un actionneur mécanique, bascule de l'état ouvert à l'état fermé lorsque les disjoncteurs disjonctent. Ainsi, dans de telles installations, les disjoncteurs agencés en grand nombre dans des armoires électriques ont chacun un interrupteur témoin relié par deux fils à un centralisateur, qui surveille l'état des disjoncteurs pour la détection des coupures de courant.

La présente invention propose de supprimer les quantités de fils électriques reliant les interrupteurs témoins au centralisateur, en embarquant dans un disjoncteur un dispositif selon l'invention qui est agencé pour surveiller l'état du disjoncteur et envoyer une information lorsque le disjoncteur est dans l'état ouvert. Cette information peut par exemple consister dans un code d'identification du disjoncteur, dont la seule émission signifie que le disjoncteur a disjoncté.

La figure 7 représente un exemple de réalisation d'un disjoncteur 90 selon l'invention, comprenant une combinaison d'un disjoncteur classique 80 et d'un dispositif 20 selon l'invention. La structure du dispositif 20 est identique à celle décrite en relation avec la figure 5 et ne sera pas décrite à nouveau. Le disjoncteur 80 comprend des bornes d'entrées T3, T4 connectées aux fils de phase et de neutre de la partie amont du réseau de distribution d'électricité, et des bornes de sortie T5, T6 connectées aux fils de phase et de neutre de la partie aval du réseau de distribution d'électricité. Le disjoncteur 80 comprend également des bornes de contrôle T7, T8 reliées aux bornes d'un interrupteur témoin 81. Les bornes T1 et T2 du dispositif 20 sont connectées aux bornes T3 et T4 du disjoncteur 80 de manière que le dispositif 20 soit alimenté électriquement quand le disjoncteur est dans l'état ouvert.

La détection par le dispositif 20 de l'état du disjoncteur 80, est assurée ici au moyen de l'interrupteur témoin. Une telle détection peut être assurée de diverses manières. Par exemple, le microcontrôleur du circuit de contrôle 60 peut comprendre deux ports d'entrée/sortie connectés aux bornes T7, T8 pour surveiller de façon cyclique l'état passant ou non passant de l'interrupteur témoin. Cette solution présente toutefois l'inconvénient que le dispositif 20 doit être en permanence sous tension, et implique une consommation électrique.

Une solution avantageuse, représentée sur la figure 7, est que la tension d'alimentation Vcc fournie par le circuit 40 soit appliquée au circuit de surveillance 50 et au circuit de contrôle 60 par l'intermédiaire de l'interrupteur témoin 81. Ainsi, le dispositif 20 reste hors tension tant que le disjoncteur est dans l'état enclenché. Lorsque l'interrupteur témoin 81 se ferme, les circuits 50, 60 sont alimentés électriquement et le circuit de contrôle 60 "sait" implicitement, à sa mise sous tension, qu'une information doit être émise sur le réseau électrique. Le circuit de contrôle 60 est donc simplement programmé pour, lorsqu'il est sous-tension, émettre une suite d'impulsions permettant d'identifier le disjoncteur. De façon générale, l'intégration du dispositif 20 dans un disjoncteur 80 pour obtenir le disjoncteur 90 selon l'invention implique une faible augmentation du prix de revient du disjoncteur, et permet en contrepartie d'importantes économies de câblage du fait de la suppression des fils électriques reliant le centralisateur et les disjoncteurs. Un récepteur d'impulsions du type décrit plus haut permet de réaliser un centralisateur sans fil capable de gérer des centaines de disjoncteurs et de fournir en temps réel une indication sur les disjoncteurs se trouvant dans l'état disjoncté.

A la lumière des exemples décrits, il apparaîtra clairement à l'homme de l'art que la présente invention est susceptible de diverses autres variantes de réalisation et applications. Notamment, bien que l'on ait décrit diverses applications du procédé de l'invention à un réseau électrique véhiculant une tension alternative, la présente invention est également applicable aux réseaux à courant continu, notamment les réseaux 400V DC utilisés dans l'industrie ou à bord des navires, les réseaux 200V DC, y compris les réseaux faible tension 12V DC présents dans les véhicules automobiles. Notamment, le procédé selon l'invention peut être utilisé pour faire émettre par un organe de véhicule (par exemple un phare de voiture) une information concernant son état (allumé, éteint, hors service, etc.). Dans les applications aux réseaux à courant continu, la surveillance de la forme d'onde de la tension véhiculée par le réseau n'est plus nécessaire puisque cette tension, étant continue, présente toujours une valeur optimale pour l'émission des impulsions parasites haute fréquence.

L'invention étant basée sur un phénomène peu étudié jusqu'à présent, il appartient à l'homme de l'art de compléter l'enseignement qui vient d'être décrit par des observations expérimentales. Ainsi, des expérimentations complémentaires ont révélé que l'amplitude des impulsions parasites de connexion peut s'avérer égale voire supérieure à celle des impulsions parasites de déconnexion. Ceci peut notamment être observé en utilisant comme élément électrique une résistance de faible valeur, par exemple quelques ohms, qui est connectée cycliquement au réseau avec un temps de connexion très faible, par exemple quelques microsecondes, et qui ainsi est traversée par un courant élevé, par exemple plusieurs ampères, lequel ne perturbe pas le réseau en raison de sa courte durée. On observe alors que l'amplitude des impulsions parasites émises lorsque la résistance est déconnectée du réseau est sensiblement supérieure à celle des impulsions parasites émises lorsque la résistance est connectée au réseau. Dans ce cas, les impulsions de déconnexion peuvent aussi être utilisées comme moyen de transmission d'une information, à la place des impulsions de connexion. Egalement, les impulsions des deux types, de connexion et de déconnexion, peuvent être toutes deux détectées pour obtenir une information redondante de détection d'impulsions permettant de reconstituer le signal de contrôle avec une fiabilité accrue.

## Revendications

1. Procédé de transmission d'une information par l'intermédiaire d'un réseau (3) de distribution d'électricité véhiculant une tension (Uac), comprenant les étapes suivants :
- connecter entre deux fils (PH, NL) du réseau un élément électrique (1, 31) en série avec un moyen interrupteur (2, 32),
- appliquer au moyen interrupteur un signal de contrôle (CS) de forme déterminée de manière que le moyen interrupteur soit successivement fermé et ouvert,
**caractérisé en ce qu'**il comprend :
- une étape de détection d'impulsions parasites qui apparaissent dans le réseau lorsque le moyen interrupteur est fermé ou est ouvert, chaque impulsion parasite comprenant un train d'ondes haute fréquence, et
- une étape de reconstitution du signal de contrôle (CS).

2. Procédé selon la revendication 1, dans lequel le moyen interrupteur (2, 32) est piloté par un signal de contrôle (CS) porteur de données (DTx), de sorte que des impulsions parasites haute fréquence porteuses de données sont émises au rythme du signal de contrôle.

3. Procédé selon la revendication 2, dans lequel le signal de contrôle (CS) est un signal codé.

4. Procédé selon l'une des revendications 1 à 3, dans lequel le réseau (3) de distribution d'électricité véhicule une tension alternative (Uac) et dans lequel le signal de contrôle (CS) est synchronisé à la forme d'onde de la tension alternative (Uac), de manière que l'interrupteur (2, 32) ne soit fermé que lorsque la tension alternative se trouve au voisinage de sa valeur crête (Umax, -Umax).

5. Procédé selon la revendication 4, dans lequel la tension alternative (Uac) est considérée comme au voisinage de sa valeur crête lorsqu'elle présente une amplitude (U1, U2) au moins égale à 50% de sa valeur crête.

6. Procédé selon l'une des revendications 4 et 5, dans lequel le signal de contrôle (CS) est synchronisé à la forme d'onde de la tension alternative de manière que l'interrupteur ne soit ouvert que lorsque la tension alternative se trouve au voisinage de zéro.

7. Procédé selon l'une des revendications 1 à 6, dans lequel le signal de contrôle (CS) est composé d'impulsions de fermeture/ouverture du moyen interrupteur de durée constante, chaque impulsion de fermeture/ouverture comprenant un front montant et/ou un niveau haut provoquant un changement dans l'état ouvert ou fermé de l'interrupteur et un front descendant et/ou un niveau bas provoquant un changement inverse de l'état de l'interrupteur.

8. Procédé selon la revendication 7, dans lequel le signal de contrôle comprend des impulsions de fermeture/ouverture d'une durée inférieure au 1/8iéme de la période de la tension alternative.

9. Procédé selon l'une des revendications 1 à 8, dans lequel l'élément électrique est un condensateur (31), une résistance, une diode électroluminescente ou une combinaison d'au moins deux de ces éléments.

10. Procédé selon l'une des revendications 1 à 9, dans lequel des impulsions parasites sont neutralisées, rejetées ou ignorées, et ne sont pas prises en compte pour reconstituer le signal de contrôle.

11. Procédé selon la revendication 10, dans lequel la détection des impulsions parasites comprend la production d'un signal image de la tension véhiculée par le réseau de distribution d'électricité, le filtrage passe haut (12) du signal image, l'échantillonnage (13) du signal image selon une fenêtre d'échantillonnage déterminée, pour obtenir des échantillons numériques du signal image, et l'analyse (14) des échantillons du signal image.

12. Procédé de mesure à distance de la consommation électrique locale d'un appareil électrique connecté à un réseau (3) de distribution d'électricité véhiculant une tension déterminée (Uac), comprenant une étape de mesure de la consommation électrique du dispositif au moyen d'un capteur de courant embarqué (70, 71), une étape d'émission et une étape de réception d'une information relative à la consommation électrique mesurée mise en oeuvre conformément au procédé selon l'une des revendications 2 à 11.

13. Procédé d'identification d'un appareil électrique connecté à un réseau (3) de distribution d'électricité véhiculant une tension déterminée (Uac), **caractérisé en ce qu'**il comprend une étape d'émission d'une suite d'impulsions parasites haute fréquence formant un code d'identification de l'appareil, mise en oeuvre conformément au procédé selon l'une des revendications 1 à 11.

14. Procédé selon la revendication 13, dans lequel l'appareil électrique est un disjoncteur (80), et dans lequel l'émission du code d'identification n'est déclenchée que lorsque le disjoncteur a disjoncté.

15. Dispositif d'émission et de réception d'une information via un réseau (3) de distribution d'électricité véhiculant une tension (Uac), comprenant :
- un dispositif (20, 20') d'émission d'impulsions sur le réseau (3) comprenant :
- un élément électrique (31) et un moyen interrupteur (32) en série connectés entre deux fils (PH, NL) du réseau, et
- des moyens (60, 61) pour appliquer au moyen interrupteur un signal de contrôle (CS) de forme déterminée de manière que le moyen interrupteur soit successivement fermé et ouvert,
**caractérisé en ce qu'**il comprend :
- un dispositif (10, 15) de détection d'impulsions parasites qui apparaissent dans le réseau lorsque le moyen interrupteur est fermé ou ouvert, chaque impulsion parasite comprenant un train d'ondes haute fréquence, le dispositif de détection comprenant des moyens (12, 13, 14, 16, 17) de reconstitution du signal de contrôle (CS).

16. Dispositif selon la revendication 15, comprenant des moyens (61) pour fournir au moyen interrupteur un signal de contrôle (CS) porteur de données.

17. Dispositif selon la revendication 16, comprenant des moyens (61) pour fournir au moyen interrupteur un signal de contrôle (CS) codé.

18. Dispositif selon l'une des revendications 15 à 17, prévu pour un réseau de distribution d'électricité véhiculant une tension alternative (Uac), dans lequel le dispositif d'émission d'impulsions comprend des moyens (50) de surveillance de l'amplitude de la tension alternative (Uac), fournissant un signal (ENB) d'autorisation d'émission d'impulsions ayant une valeur déterminée lorsque la tension alternative se trouve au voisinage de sa valeur crête (Umax, -Umax), et des moyens pour ne fermer l'interrupteur que lorsque le signal d'autorisation d'émission d'impulsions présente la valeur déterminée.

19. Dispositif selon la revendication 18, dans lequel les moyens de surveillance (50) fournissent un signal d'autorisation d'émission d'impulsions ayant la valeur déterminée lorsque l'amplitude de la tension alternative vaut au moins 50% de sa valeur crête.

20. Dispositif selon l'une des revendications 18 et 19, dans lequel les moyens de surveillance (50) comprennent un redresseur (51) fournissant une tension redressée (Ur') simple ou double alternance dont l'amplitude est représentative de l'amplitude de la tension alternative (Uac), et un comparateur (56) recevant sur une entrée une tension de référence (Vref) et sur une autre entrée la tension redressée (Ur'), fournissant le signal (ENB) d'autorisation d'émission de données.

21. Dispositif selon l'une des revendications 15 à 20, dans lequel les moyens (60, 61) pour fournir le signal de contrôle fournissent un signal de contrôle (CS) composé d'impulsions de fermeture/ouverture du moyen interrupteur de durée constante, chaque impulsion comprenant un front montant et/ou un niveau haut provoquant un changement dans l'état ouvert ou fermé de l'interrupteur et un front descendant et/ou un niveau bas provoquant un changement inverse de l'état de l'interrupteur.

22. Dispositif selon la revendication 21 et l'une des revendications 18 à 20, dans lequel les moyens (60, 61) pour fournir le signal de contrôle fournissent des impulsions de fermeture/ouverture d'une durée au moins inférieure au 1/8ième de la période de la tension alternative.

23. Dispositif selon l'une des revendications 15 à 22, dans lequel l'élément électrique est un condensateur (31), une résistance, une diode électroluminescente ou une combinaison d'au moins deux de ces éléments.

24. Dispositif selon l'une des revendications 15 à 23, dans lequel le moyen interrupteur est un triac (32), un transistor MOS ou un relais.

25. Dispositif selon l'une des revendications 15 à 24, dans lequel le signal de contrôle (CS) est fourni par un microcontrôleur ou un microprocesseur (61).

26. Dispositif (20') selon l'une des revendications 15 à 25, dans lequel le dispositif (20, 20') d'émission d'impulsions comprend des moyens (70, 71) de mesure de courant et est agencé pour émettre sous forme d'impulsions parasites haute fréquence une information relative à un courant mesuré.

27. Dispositif selon l'une des revendications 15 à 26, dans lequel le dispositif de détection (10) comprend des moyens (13, 14) pour filtrer, rejeter ou ignorer des impulsions parasites afin de ne pas prendre en compte de telles impulsions dans la reconstitution du signal de contrôle.

28. Dispositif selon l'une des revendications 15 à 27, prévu pour un réseau de distribution d'électricité véhiculant une tension alternative (Uac), dans lequel le dispositif de détection (10) comprend des moyens pour fournir un signal image de la tension alternative, et des moyens (12) de filtrage passe-haut du signal image, pour en extraire les impulsions parasites haute fréquence.

29. Dispositif selon l'une des revendications 15 à 27, dans lequel le dispositif de détection (15) comprend une antenne (16) pour détecter les impulsions parasites haute fréquence en utilisant une composante électromagnétique des impulsions parasites.

30. Dispositif selon l'une des revendications 28 et 29, dans lequel le dispositif de détection (10, 15) comprend des moyens (13) d'échantillonnage du signal reçu, et des moyens (14) d'analyse des échantillons du signal reçu, pour détecter la présence d'impulsions parasites haute fréquence.

31. Dispositif disjoncteur (90) présentant un état fermé et un état ouvert, **caractérisé en ce qu'**il comprend un dispositif d'émission d'impulsions (20) selon l'une des revendications 15 à 25, pour émettre une suite d'impulsions déterminée lorsque le dispositif disjoncteur est dans l'état ouvert.

32. Dispositif disjoncteur selon la revendication 31, comprenant un interrupteur témoin (81) qui bascule de l'état ouvert à l'état fermé lorsque le dispositif disjoncteur bascule de l'état fermé à l'état ouvert, et dans lequel tout ou partie (50, 60) du dispositif (20) d'émission d'impulsions est alimenté électriquement par l'intermédiaire de l'interrupteur témoin (81), de sorte que le dispositif d'émission d'impulsions est inactif tant que le disjoncteur est dans l'état fermé.

## Claims

1. Method for transmitting information through a power distribution network carrying a voltage, comprising:
- connecting between two wires of the network an electric element in series with a switching means,
- applying to the switching means a control signal of determined shape so that the switching means is successively closed and opened,
comprising:
- detecting noise pulses which appear in the network when the switching means is closed or opened, each noise pulse comprising a high-frequency wave-train, and
- reconstructing the control signal.

2. Method according to claim 1, wherein the switching means is driven by a data carrier control signal, so that high-frequency noise pulses carrying data are transmitted at the rhythm of the control signal.

3. Method according to claim 2, wherein the control signal is a coded signal.

4. Method according to one of claims 1 to 3, wherein the power distribution network carries an alternating voltage and wherein the control signal is synchronized with the waveform of the alternating voltage, so that the switch is only closed when the alternating voltage is near the peak value thereof.

5. Method according to claim 4, wherein the alternating voltage is considered to be near the peak value thereof when it has an amplitude at least equal to 50% of the peak value thereof.

6. Method according to one of claims 4 and 5, wherein the control signal is synchronized with the waveform of the alternating voltage so that the switch is only opened when the alternating voltage is near zero.

7. Method according to one of claims 1 to 6, wherein the control signal consists of make/break pulses of the switching means of constant duration, each make/break pulse comprising a rising edge and/or a high level causing a change in the opened or closed state of the switch and a falling edge and/or a low level causing an inverse change of the state of the switch.

8. Method according to claim 7, wherein the control signal comprises make/break pulses of a duration lower than 1/8^{th} of the period of the alternating voltage.

9. Method according to one of claims 1 to 8, wherein the electric element is a capacitor, a resistor, a LED or a combination of at least two of these elements.

10. Method according to one of claims 1 to 9, wherein noise pulses are neutralized, rejected or ignored, and are not taken into account to reconstitute the control signal.

11. Method according to claim 10, wherein detecting the noise pulses comprises producing a signal image of the voltage carried by the power distribution network, high-pass filtering the image signal, sampling the image signal according to a determined sampling window, to obtain digital samples of the image signal, and analyzing the samples of the image signal.

12. Method for remotely measuring the local electrical consumption of an electrical device connected to a power distribution network carrying a determined voltage, comprising measuring the electrical consumption of the device by means of a built-in current sensor, transmitting and receiving information about the electrical consumption measured implemented in accordance with the method according to one of claims 2 to 11.

13. Method for identifying an electrical device connected to a power distribution network carrying a determined voltage, comprising transmitting a succession of high-frequency noise pulses making an identification code of the device, implemented in accordance with the method according to one of claims 1 to 11.

14. Method according to claim 13, wherein the electrical device is a circuit-breaker, and wherein the transmission of the identification code is only triggered when the circuit-breaker has switched.

15. Device for transmitting and receiving information via a power distribution network carrying a voltage, comprising:
- a device for transmitting pulses on the network comprising:
- an electric element and a switching means in series connected between two wires of the network, and
- means for applying to the switching means a control signal of determined shape so that the switching means is successively closed and opened,
comprising:
- a device for detecting noise pulses which appear in the network when the switching means is closed or opened, each noise pulse comprising a high-frequency wave-train, the detection device comprising means for reconstructing the control signal.

16. Device according to claim 15, comprising means for supplying to the switching means a data carrier control signal.

17. Device according to claim 16, comprising means for supplying to the switching means an encoded control signal.

18. Device according to one of claims 15 to 17, provided for a power distribution network carrying an alternating voltage, wherein the device for transmitting pulses comprises means for monitoring the amplitude of the alternating voltage, supplying a signal for authorizing the transmission of pulses having a determined value when the alternating voltage is near the peak value thereof, and means for closing the switch only when the signal for authorizing the transmission of pulses has the determined value.

19. Device according to claim 18, wherein the monitoring means supply a signal for authorizing the transmission of pulses having the determined value when the amplitude of the alternating voltage worth at least 50% of the peak value thereof.

20. Device according to one of claims 18 and 19, wherein the monitoring means comprise a rectifier supplying a half-wave or full-wave rectified voltage the amplitude of which is representative of the amplitude of the alternating voltage, and a comparator receiving on an input a reference voltage and on another input the rectified voltage, supplying the signal for authorizing the transmission of data.

21. Device according to one of claims 15 to 20, wherein the means for supplying the control signal supply a control signal consisting of make/break pulses of the switching means of constant duration, each pulse comprising a rising edge and/or a high level causing a change in the opened or closed state of the switch and a falling edge and/or a low level causing an inverse change of the state of the switch.

22. Device according to claim 21 and one of claims 18 to 20, wherein the means for supplying the control signal supply make/break pulses of a duration at least lower than 1/8^{th} of the period of the alternating voltage.

23. Device according to one of claims 15 to 22, wherein the electric element is a capacitor, a resistor, a LED or a combination of at least two of these elements.

24. Device according to one of claims 15 to 23, wherein the switching means is a triac, a MOS transistor or a relay.

25. Device according to one of claims 15 to 24, wherein the control signal is supplied by a microcontroller or a microprocessor.

26. Device according to one of claims 15 to 25, wherein the device for transmitting pulses comprises current measuring means and is arranged to transmit in the form of high-frequency noise pulses information about a measured current.

27. Device according to one of claims 15 to 26, wherein the detection device comprises means for filtering, rejecting or ignoring noise pulses in order not to take into account such pulses in the reconstruction of the control signal.

28. Device according to one of claims 15 to 27, provided for a power distribution network carrying an alternating voltage, wherein the detection device comprises means for supplying a signal image of the alternating voltage, and means for high-pass filtering the image signal, to extract therefrom high-frequency noise pulses.

29. Device according to one of claims 15 to 27, wherein the detection device comprises an antenna to detect the high-frequency noise pulses using an electromagnetic component of the noise pulses.

30. Device according to one of claims 28 and 29, wherein the detection device comprises means for sampling the signal received, and means for analyzing samples of the signal received, to detect the presence of high-frequency noise pulses.

31. Circuit breaker device having a closed state and an opened state, comprising a device for transmitting pulses according to one of claims 15 to 25, to transmitting a succession of determined pulses when the circuit breaker device is in the opened state.

32. Circuit breaker device according to claim 33, comprising a pilot switch which switches from the opened state to the closed state when the circuit breaker device switches from the closed state to the opened state, and wherein all or part of the device for transmitting pulses is electrically powered through the pilot switch, so that the device for transmitting pulses is inactive as long as the circuit breaker is in the closed state.

## Patentansprüche

1. Verfahren zum Übertragen einer Information über ein eine Spannung (Uac) führendes Elektrizitätsverteilernetz (3), das die folgenden Schritte umfasst:
- das Zwischenschalten eines elektrischen Elements (1, 31) zwischen zwei Leitungen (PH, NL) des Netzes in Serie mit einem Schaltermittel (2, 32),
- das Anlegen eines Steuersignals (CS) mit bestimmter Form an das Schaltermittel, sodass das Schaltermittel in der Folge geschlossen oder geöffnet wird,
**dadurch gekennzeichnet, dass** es Folgendes umfasst:
- einen Schritt des Detektierens von Störimpulsen, die im Netz auftreten, wenn das Schaltermittel geschlossen oder geöffnet ist, wobei jeder Störimpuls einen hochfrequenten Wellenzug umfasst, und
- einen Schritt des Wiederherstellens des Steuersignals (CS).

2. Verfahren nach Anspruch 1, wobei das Schaltermittel (2, 32) von einem Steuersignal (CS) gesteuert ist, das Daten (DTx) trägt, sodass hochfrequente Störimpulse, die Daten tragen, im Rhythmus des Steuersignals ausgegeben werden.

3. Verfahren nach Anspruch 2, wobei das Steuersignal (CS) ein codiertes Signal ist.

4. Verfahren nach einem der Ansprüche 1 bis 3, wobei das Elektrizitätsverteilernetz (3) eine Wechselspannung (Uac) führt und wobei das Steuersignal (CS) auf die Wellenformen der Wechselspannung (Uac) synchronisiert ist, sodass der Schalter (2, 32) nur dann geschlossen ist, wenn sich die Wechselspannung im Bereich ihres Spitzenwerts (Umax, -Umax) befindet.

5. Verfahren nach Anspruch 4, wobei die Wechselspannung (Uac) als im Bereich ihres Spitzenwerts befindlich betrachtet wird, wenn sie eine Amplitude (U1, U2) von mindestens gleich 50 % ihres Spitzenwerts aufweist.

6. Verfahren nach einem der Ansprüche 4 oder 5, wobei das Steuersignal (CS) auf die Wellenform der Wechselspannung synchronisiert ist, sodass der Schalter nur dann offen ist, wenn sich die Wechselspannung im Bereich von null befindet.

7. Verfahren nach einem der Ansprüche 1 bis 6, wobei das Steuersignal (CS) aus Impulsen zum Schließen/Öffnen des Schaltermittels von konstanter Dauer besteht, wobei jeder Impuls zum Schließen/Öffnen eine ansteigende Front und/oder eine hohe Höhe umfasst, die eine Änderung des offenen oder geschlossenen Zustands des Schalters bewirkt, und eine absteigende Front und/oder eine niedrige Höhe umfasst, die eine umgekehrte Änderung des Zustands des Schalters bewirkt.

8. Verfahren nach Anspruch 7, wobei das Steuersignal Impulse zum Schließen/Öffnen mit einer Dauer umfasst, die geringer ist als 1/8 der Periode der Wechselspannung.

9. Verfahren nach einem der Ansprüche 1 bis 8, wobei das elektrische Element ein Kondensator (31), ein Widerstand, eine Leuchtdiode oder eine Kombination aus mindestens zwei dieser Elemente ist.

10. Verfahren nach einem der Ansprüche 1 bis 9, wobei Störimpulse neutralisiert, gesperrt oder ignoriert werden und bei der Wiederherstellung des Steuersignals nicht berücksichtigt werden.

11. Verfahren nach Anspruch 10, wobei die Detektion der Störimpulse das Erzeugen eines Spiegelsignals der vom Elektrizitätsverteilernetz geführten Spannung, das Hochpassfiltern (12) des Spiegelsignals, das Abtasten (13) des Spiegelsignals gemäß einem bestimmten Abtastfenster, um digitale Proben des Spiegelsignals zu erhalten, und das Analysieren (14) der Proben des Spiegelsignals umfasst.

12. Verfahren zum Fernmessen des lokalen Elektrizitätsverbrauchs eines mit einem Elektrizitätsverteilernetz (3), das eine bestimmte Spannung (Uac) führt, verbundenen elektrischen Geräts, das einen Schritt des Messen des Elektrizitätsverbrauchs der Vorrichtung mittels eines eingebauten Stromsensors (70, 71), einen Schritt des Ausgebens und einen Schritt des Empfangens einer Information über den Elektrizitätsverbrauch umfasst und das gemäß dem Verfahren nach einem der Ansprüche 2 bis 11 durchgeführt wird.

13. Verfahren zum Identifizieren eines mit einem Elektrizitätsverteilernetz (3), das eine bestimmte Spannung (Uac) führt, verbundenen elektrischen Geräts, **dadurch gekennzeichnet, dass** es einen Schritt des Ausgebens einer Abfolge von hochfrequenten Störimpulsen, die einen Identifikationscode des Geräts bilden, umfasst und es gemäß dem Verfahren nach einem der Ansprüche 1 bis 11 durchgeführt wird.

14. Verfahren nach Anspruch 13, wobei das elektrische Gerät ein Schutzschalter (80) ist, wobei die Ausgabe des Identifikationscodes nur dann veranlasst wird, wenn der Schutzschalter abgeschaltet hat.

15. Vorrichtung zum Ausgeben und Empfangen einer Information über ein eine Spannung (Uac) führendes Elektrizitätsverteilernetz (3), die Folgendes umfasst:
- eine Vorrichtung (20, 20') zum Ausgeben von Impulsen im Netz (3), umfassend:
- ein elektrisches Element (31) und ein Schaltermittel (32), die zwischen zwei Leitungen (PH, NL) des Netzes in Serie geschaltet sind; und
- Mittel (60, 61) zum Anlegen eines Steuersignals (CS) mit bestimmter Form an das Schaltermittel, sodass das Schaltermittel in der Folge geschlossen oder geöffnet wird,
**dadurch gekennzeichnet, dass** sie Folgendes umfasst:
- eine Vorrichtung (10, 15) zum Detektieren von Störimpulsen, die im Netz auftreten, wenn das Schaltermittel geschlossen oder geöffnet ist, wobei jeder Störimpuls einen hochfrequenten Wellenzug umfasst, wobei die Vorrichtung zum Detektieren Mittel (12, 13, 14, 16, 17) zum Wiederherstellen des Steuersignals (CS) umfasst.

16. Vorrichtung nach Anspruch 15, umfassend Mittel (61) zum Bereitstellen eines Steuersignals (CS), das Daten trägt, an das Schaltermittel.

17. Vorrichtung nach Anspruch 16, umfassend Mittel (61) zum Bereitstellen eines codierten Steuersignals (CS) an das Schaltermittel.

18. Vorrichtung nach einem der Ansprüche 15 bis 17, die für ein Elektrizitätsverteilernetz (3), das eine Wechselspannung (Uac) führt, vorgesehen ist, wobei die Vorrichtung zum Ausgeben von Impulsen Mittel (50) zum Überwachen der Amplitude der Wechselspannung (Uac) umfasst, die ein Signal (ENB) zur Autorisierung der Ausgabe von Impulsen mit einem bestimmten Wert bereitstellen, wenn sich die Wechselspannung im Bereich ihres Spitzenwerts (Umax, -Umax) befindet, und Mittel umfasst, um den Schalter nur dann zu schließen, wenn das Signal zur Autorisierung der Ausgabe von Impulsen den bestimmten Wert aufweist.

19. Vorrichtung nach Anspruch 18, wobei die Mittel zum Überwachen (50) ein Signal zur Autorisierung der Ausgabe von Impulsen mit dem bestimmten Wert bereitstellen, wenn die Amplitude der Wechselspannung einen Wert von mindestens 50 % ihres Spitzenwerts aufweist.

20. Vorrichtung nach einem der Ansprüche 18 oder 19, wobei die Mittel zum Überwachen (50) einen Gleichrichter (51) umfassen, der eine einweg- oder zweiweggleichgerichtete Spannung (Ur') bereitstellt, deren Amplitude für die Amplitude der Wechselspannung (Uac) repräsentativ ist, und einen Vergleicher (56) umfassen, der an einem Eingang eine Referenzspannung (Vref) und an einem anderen Eingang die gleichgerichtete Spannung (Ur') empfängt und das Signal (ENB) zur Autorisierung der Ausgabe von Daten bereitstellt.

21. Vorrichtung nach einem der Ansprüche 15 bis 20, wobei die Mittel (60, 61) zum Bereitstellen des Steuersignals ein Steuersignal (CS) bereitstellen, das aus Impulsen zum Schließen/Öffnen des Schaltermittels von konstanter Dauer besteht, wobei jeder Impuls eine ansteigende Front und/oder eine hohe Höhe umfasst, die eine Änderung des offenen oder geschlossenen Zustands des Schalters bewirkt, und eine absteigende Front und/oder eine niedrige Höhe umfasst, die eine umgekehrte Änderung des Zustands des Schalters bewirkt.

22. Vorrichtung nach Anspruch 21 oder einem der Ansprüche 18 bis 20, wobei die Mittel (60, 61) zum Bereitstellen des Steuersignals Impulse zum Schließen/Öffnen mit einer Dauer bereitstellen, die mindestens geringer ist als 1/8 der Periode der Wechselspannung.

23. Vorrichtung nach einem der Ansprüche 15 bis 22, wobei das elektrische Element ein Kondensator (31), ein Widerstand, eine Leuchtdiode oder eine Kombination aus mindestens zwei dieser Elemente ist.

24. Vorrichtung nach einem der Ansprüche 15 bis 23, wobei das Schaltermittel ein Triac (32), ein MOS-Transistor oder ein Relais ist.

25. Vorrichtung nach einem der Ansprüche 15 bis 24, wobei das Steuersignal (CS) von einem Mikrocontroller oder einem Mikroprozessor (61) bereitgestellt wird.

26. Vorrichtung (20') nach einem der Ansprüche 15 bis 25, wobei die Vorrichtung (20, 20') zum Ausgeben von Impulsen Mittel (70, 71) zum Messen von Strom umfasst und angeordnet ist, um eine Information über einen gemessenen Strom in Form von hochfrequenten Störimpulsen auszugeben.

27. Vorrichtung nach einem der Ansprüche 15 bis 26, wobei die Vorrichtung zum Detektieren (10) Mittel (13, 14) zum Filtern, Sperren oder Ignorieren von Störimpulsen umfasst, um derartige Impulse bei der Wiederherstellung des Steuersignals nicht zu berücksichtigen.

28. Vorrichtung nach einem der Ansprüche 15 bis 27, die für ein Elektrizitätsverteilernetz (3), das eine Wechselspannung (Uac) führt, vorgesehen ist, wobei die Vorrichtung zum Detektieren (10) Mittel zum Bereitstellen eines Spiegelsignals der Wechselspannung und Mittel (12) zum Hochpassfiltern des Spiegelsignals, um daraus die hochfrequenten Störimpulse zu extrahieren, umfasst.

29. Vorrichtung nach einem der Ansprüche 15 bis 27, wobei die Vorrichtung zum Detektieren (15) eine Antenne (16) umfasst, um unter Verwendung einer elektromagnetischen Komponente der Störimpulse die hochfrequenten Störimpulse zu detektieren.

30. Vorrichtung nach einem der Ansprüche 28 oder 29, wobei die Vorrichtung zum Detektieren (10, 15) Mittel (13) zum Abtasten des empfangenen Signals und Mittel (14) zum Analysieren der Proben des empfangenen Signals umfasst, um die Gegenwart von hochfrequenten Störimpulsen zu detektieren.

31. Schutzschaltervorrichtung (90), die einen geschlossenen Zustand und einen offenen Zustand aufweist, **dadurch gekennzeichnet, dass** sie eine Vorrichtung zum Ausgeben von Impulsen (20) nach einem der Ansprüche 15 bis 25 umfasst, um eine bestimmte Abfolge von Impulsen auszugeben, wenn die Schutzschaltervorrichtung im offenen Zustand vorliegt.

32. Schutzschaltervorrichtung nach Anspruch 31, umfassend einen Kontrollschalter (81), der vom offenen Zustand in den geschlossenen Zustand kippt, wenn die Schutzschaltervorrichtung vom geschlossenen Zustand in den offenen Zustand kippt, wobei die ganze oder ein Teil (50, 60) der Vorrichtung (20) zum Ausgeben von Impulsen über den Kontrollschalter (81) elektrisch gespeist wird, sodass die Vorrichtung zum Ausgeben von Impulsen inaktiv ist, solange der Schutzschalter im geschlossenen Zustand vorliegt.
